# EUROPÄISCHE PATENTSCHRIFT

(11) **EP 2 950 296 B1**
(45) Veröffentlichungstag und Bekanntmachung des Hinweises auf die Patenterteilung: **27.12.2017**
(21) Anmeldenummer: 15168739.9
(22) Anmeldetag: 21.05.2015
(51) Int. Cl.: G09F 3/00, H02B 1/06, H05K 7/14, H01R 9/26, H01R 13/639

(54) **GEHÄUSE FÜR ELEKTROBAUGRUPPEN ZUR MONTAGE AUF EINER TRAGESCHIENE SOWIE GEHÄUSEANORDNUNG**
HOUSING FOR ELECTRO ASSEMBLIES TO BE MOUNTED ON A SUPPORT RAIL AND HOUSING ASSEMBLY
BOÎTIER POUR COMPOSANTS ÉLECTRIQUES DESTINÉ À ÊTRE MONTÉ SUR UN RAIL PORTEUR ET SYSTÈME DE BOÎTIER

(30) Priorität: 30.05.2014 DE 102014210305; 06.10.2014 DE 102014220169
(43) Veröffentlichungstag der Anmeldung: 02.12.2015
(73) Patentinhaber: Power Plus Communications AG, 68167 Mannheim (DE)
(72) Erfinder: Veselcic, Marko, 67122 Altrip (DE)
(74) Vertreter: Patent- und Rechtsanwälte Ullrich & Naumann

(56) Entgegenhaltungen:
- EP-A1- 0 918 386
- EP-A1- 1 622 095
- WO-A1-97/21202
- DE-U1- 20 005 532
- DE-U1-202011 050 458
- US-A1- 2004 267 109

## Beschreibung

Die Erfindung betrifft ein Gehäuse für Elektrobaugruppen zur Montage auf einer Tragschiene, wobei das Gehäuse aus mindestens zwei Gehäuseteilen aufgebaut ist, wobei das Gehäuse eine zur Tragschiene zugewandte Seite - Montageseite - und eine Frontseite aufweist, wobei die beiden/zwei der Gehäuseteile entlang einer Stoßkante, die zumindest teilweise entlang der Frontseite verläuft, formschlüssig und voneinander trennbar zusammengefügt sind. Die Erfindung betrifft ferner eine zugehörige Gehäuseanordnung.

Gehäuse für Elektrobaugruppen haben unter anderem die Aufgabe, gefährliche elektrische Spannungen an der in dem Gehäuse enthaltenen Elektrobaugruppe von der Umgebung fernzuhalten. Dies ist besonders wichtig, wenn Lebewesen in die Nähe der Elektrobaugruppe gelangen können. In diesem Fall wird üblicherweise ab 48 Volt von einer gefährlichen Spannung gesprochen. Bei Gehäusen zur Montage auf Tragschienen soll das Gehäuse zudem die Installation der Elektrobaugruppen erleichtern und sichere und strukturierte Systeme ermöglichen. Die in Europa vermutlich am weitesten verbreitete Tragschiene ist als Hutschiene bekannt und ist nach EN 50022 genormt. Die Abmessungen der zugehörigen Gehäuse sowie deren Einbaumaße sind in Deutschland nach DIN 43880 genormt. Hutschienen finden beispielsweise in Elektroverteilern Anwendung und tragen die meisten oder gar alle der in dem Elektroverteiler installierten Geräte, wie Sicherungsautomaten, Fehlerstromschutzschalter, Überspannungsableiter, Steuergeräte, Zeitschaltuhren oder auch intelligente Stromzähler (SmartMeter).

Die Elektrobaugruppen innerhalb der Gehäuse sind meist auf Platinen aufgebaut. Zum Positionieren und Fixieren der Platinen innerhalb der Gehäuse sind verschiedene Mechanismen gebräuchlich. In einigen Fällen werden Muttern in eine der Gehäusewandungen eingelassen, an die die Platine angeschraubt ist. In anderen Fällen sind Spreizmuttern an einer der Gehäusewandungen ausgebildet, in die die Platine eingesteckt wird. Des Weiteren sind Führungsschienen bekannt, die innerhalb des Gehäuses meist an gegenüberliegenden Wandungen ausgebildet sind und in die eine Platine eingeschoben wird.

In der Praxis sind Hutschienengehäuse bekannt, die aus zwei oder mehr Gehäuseteilen bestehen und die nach Installation der Elektrobaugruppe in dem Gehäuse und nach Zusammenfügen der Gehäuseteile wieder geöffnet werden können. Die Firma Werner Langer GmbH & Co KG bietet beispielsweise ein derartiges Hutschienengehäuse an, das aus drei Einzelteilen besteht und in das Platinen in Führungsschienen parallel zur Front eingesteckt werden können. Das symmetrische, zweiteilige Grundgehäuse wird entlang dieser Führungsschienen zusammengefügt und dann durch einen Deckel verschlossen, der das Grundgehäuse in dem der Hutschiene abgewandten Randbereich umschließt. Dadurch kann mit dem Gehäuse eine Vielzahl von Anwendungsszenarien abgedeckt werden.

Problematisch ist ein wiederöffenbares Gehäuse dann, wenn innerhalb des Gehäuses eine sicherheitsrelevante Baugruppe angeordnet ist. Eine derartige Baugruppe ist beispielsweise ein Smart Meter Gateway nach "FNN MS2020 - Lastenheft Konstruktion, Basiszähler und Smart-Meter-Gateway" (FNN = Forum Netztechnik und Netzbetrieb im VDE (Verband der Elektrotechnik, Elektronik und Informationstechnik e.V.); MS2020 = Messsystem2020, ein Projekt des VDE). In solchen Fällen muss das Gehäuse derart ausgebildet sein, dass eine Manipulation der innenliegenden Baugruppe durch konstruktive Mittel erschwert wird. Ein Kernpunkt dabei ist es, mittels eines oder mehrerer Sicherungselemente ein einmaliges Öffnen des Gehäuses zu erkennen. Gebräuchlichste Sicherungselemente sind Siegeletikette und Plomben, die derart an das Gehäuse angebracht sind, dass ein Öffnen des Gehäuses zwangläufig zum Brechen der Sicherungselements führt oder dass ein Öffnen ohne vorheriges Zerstören des Sicherungselements nicht möglich ist.

Die aus der Praxis bekannten Hutschienengehäuse haben jedoch den entscheidenden Nachteil, dass ein angebrachtes Sicherungselement nicht sichtbar oder zumindest teilweise verdeckt ist, wenn das Hutschienengehäuse auf die Hutschiene montiert ist. Üblicherweise ist auf einer Tragschiene eine größere Anzahl von Gehäusen dicht nebeneinander angeordnet. Zudem ist meist eine Berührungsschutzabdeckung installiert, die eine Berührung von Verteilschienen oder Kontakten verhindern soll. Dadurch ist sehr häufig lediglich die Frontseite der Gehäuse sichtbar, während die Montageseite (also die der Tragschiene zugewandte Seite) und der Großteil der weiteren Seiten des Gehäuses verdeckt sind. Wenn kontrolliert werden soll, ob beispielsweise ein Siegeletikett intakt ist, muss häufig die Berührungsschutzabdeckung entfernt und gegebenenfalls sogar das Gehäuse aus der Hutschiene entnommen werden. Die Berührungsschutzabdeckung darf aber nur vom Energieversorgungsunternehmen oder einer beauftragten Fachkraft abgenommen werden. Da diese Personen bei einfachen Kontrollen üblicherweise nicht zur Verfügung stehen, stellt diese Herangehensweise einen nicht unerheblichen Aufwand dar. Ein Endkunde hat daher keine Möglichkeit, den Zustand des Sicherungselements zu überprüfen.

Bei dem Tragschienengehäuse gemäß DE 20 2011 050 458 U1 ist eine Plombe als Sicherungselement vorgesehen, das ohne vorherige Demontage des Gehäuses prüfbar ist. Das Gehäuse besteht aus zwei Gehäuseschalen und einem Deckel und umschließt bereits auf der Tragschiene vorhandene Elemente, beispielsweise Anschlussklemmen. Die beiden Gehäuseschalen sind in einer Ebene parallel zu der Tragschiene und senkrecht zur Tragschienenebene zusammengefügt und sind im Wesentlichen identisch aufgebaut. An den Seitenwandungen der beiden Gehäuseschalen sind jeweils Kopplungsteile ausgebildet, die in Führungsschienen an der benachbarten Gehäuseschale eingreifen und die beiden Gehäuseschalen zusammenhalten. Der Deckel weist an einer Seite Rastnasen auf, die bei Einsetzen des Deckels in das Gehäuse in zugehörige Aufnahmen an den Gehäuseschalen eingreifen. An der gegenüberliegenden Seite des Deckels ist eine Abwinkelung ausgebildet, die bei eingesetztem Deckel bündig mit der Oberkante der Gehäuseschalen abschließt. Bei der Oberkante des Gehäuses ist in jeder Gehäuseschale und in der Abwinkelung des Deckels jeweils eine Durchführung ausgebildet, die bei zusammengesetztem Gehäuse eine gemeinsame Durchführung bilden. Die gemeinsame Durchführung wird zur Sicherung der Gehäuseschalen und des Deckels mittels einer einzelnen Plombe genutzt. Durch die Anordnung der Plombe bei der Frontseite kann ein Zerstören der Plombe auch im eingebauten Zustand erkannt werden. Nachteilig an diesem Gehäuse ist, dass die Kopplungsteile und Führungsschienen relativ viel Platz im Gehäuse benötigen und dass sie kompliziert herzustellen sind.

Der vorliegenden Erfindung liegt daher die Aufgabe zugrunde, ein Gehäuse und eine Gehäuseanordnung der eingangs genannten Art derart auszugestalten und weiterzubilden, dass auch nach der Montage des Gehäuses auf der Tragschiene ohne vorherige Demontage des Gehäuses ein Öffnen des Gehäuses erkennbar gemacht werden kann.

Erfindungsgemäß wird die voranstehende Aufgabe durch die Merkmale des Anspruchs 1 gelöst. Danach ist das in Rede stehende Gehäuse dadurch gekennzeichnet, dass an der Frontseite bei der Stoßkante ein Bereich zum Anbringen eines Sicherungselementes - Sicherungsbereich - ausgebildet ist, wobei sich der Sicherungsbereich über mindestens zwei der Gehäuseteile erstreckt, dass mindestens eines der Gehäuseteile in dem Sicherungsbereich eine Lasche aufweist, die in eine korrespondierende Ausnehmung an der Oberfläche des angrenzenden Gehäuseteils eingreift und die den an der Oberfläche des Gehäuses sichtbaren Verlauf der Stoßkante verändert, wodurch bei einem Öffnen des Gehäuses durch Verschwenken der Gehäuseteile relativ zueinander und entlang der Stoßkante an der Frontseite die Lasche und die Ausnehmung relativ zueinander verschwenken und dadurch Scherkräfte auf ein in dem Sicherungsbereich angebrachtes Sicherungselement entstehen.

Hinsichtlich einer Gehäuseanordnung ist die voranstehende Aufgabe durch die Merkmale des Anspruchs 14 gelöst. Danach umfasst die Gehäuseanordnung ein Gehäuse entsprechend dem zuvor genannten Aspekt der Erfindung und ein Sicherungselement, das in dem Sicherungsbereich angebracht ist, wobei das Sicherungselement als Siegeletikett ausgebildet ist und wobei das Sicherungselement derart ausgestaltet ist, dass es durch die Scherkräfte bei Öffnen des Gehäuses, insbesondere durch Verschwenken der Gehäuseteile relativ zueinander und entlang der Stoßkante an der Frontseite, beschädigt wird.

In erfindungsgemäßer Weise ist zunächst erkannt worden, dass bei einem mehrteiligen Gehäuse (also einem Gehäuse mit zwei oder mehr Gehäuseteilen) nach Anbringen eines Sicherungselements ein Öffnen des Gehäuses besonders gut erkannt werden kann, wenn das Sicherungselement an der Frontseite des Gehäuses angebracht ist. Unter Frontseite des Gehäuses wird im vorliegenden Kontext die Seite des Gehäuses verstanden, die auch nach der Montage des Gehäuses auf der Tragschiene und ohne Zugangsberechtigung zu einem abgedeckten Bereich (beispielsweise durch eine Berührungsschutzabdeckung) noch erkennbar ist. Bei einem Hutschienengehäuse ist dies beispielsweise der Teil des Gehäuses, der durch die Berührungsschutzabdeckung geführt ist und damit auch ohne Demontage der Berührungsschutzabdeckung und ohne Entnahme des Gehäuses aus der Hutschiene erkennbar ist. An der Frontseite sind üblicherweise auch Anzeigen der in dem Gehäuse enthaltenen Elektrobaugruppe, wie beispielsweise Statusleuchten oder kleinere LCD (Liquid Crystal Display)-Anzeigen, angeordnet.

Da Sicherungselemente ein Öffnen des Gehäuses erkennbar machen sollen, sind diese an einer Stoßkante angebracht, entlang der die beiden Gehäuseteile oder - bei einem mehr als zwei Teile umfassenden Gehäuse - mindestens zwei der Gehäuseteile zusammengefügt sind. Wenn das Sicherungselement erfindungsgemäß an der Frontseite angebracht werden soll, muss die Stoßkante zumindest teilweise entlang der Frontseite verlaufen. Im Bereich der Stoßkante an der Frontseite ist ein Bereich ausgebildet, der zum Anbringen eines Sicherungselements ausgebildet ist. Dieser Bereich wird nachfolgend als Sicherungsbereich bezeichnet. Der Sicherungsbereich erstreckt sich über die beiden Gehäusesteile oder mindestens zwei der Gehäuseteile. Auf diese Weise kann bei Anbringen eines Sicherungselements ein Öffnen des Gehäuses in Richtungen senkrecht zur Stoßkante detektiert werden.

Zum Verhindern eines unerkannten Öffnens durch Verschwenken der Gehäuseteile relativ zueinander und entlang der Stoßkante an der Frontseite, ist die Stoßkante an der Frontseite auf besondere Art und Weise ausgestaltet. Erfindungsgemäß ist hierzu im Sicherungsbereich eine Lasche ausgebildet. Diese Lasche greift in eine korrespondierende Ausnehmung an der Oberfläche des Gehäuseteils ein, das an den Gehäuseteil mit der Lasche angrenzt. Da das Sicherungselement in dem Sicherungsbereich angebracht ist und die Lasche Teil des Sicherungsbereichs ist, kann durch diese sehr einfache Maßnahme erreicht werden, dass bei Verschwenken der Gehäuseteile relativ zueinander und entlang der Stoßkante an der Frontseite sich die Lasche und die Ausnehmung relativ zueinander verschwenken. Auf diese Weise entstehen bei Verschwenken der Gehäuseteile Scherkräfte auf ein Sicherungselement, das im Sicherungsbereich angebracht ist. Bei einem Gehäuse mit drei oder mehr Gehäuseteilen ist eine weitere Voraussetzung, dass die Verbindungen zu den anderen Gehäuseteilen derart ausgebildet sind, dass ein Öffnen des Gehäuses entlang einer nicht durch den Sicherungsbereich verlaufenden Stoßkante nur dann möglich ist, wenn das Gehäuse entlang der Stoßkante an der Frontseite bereits geöffnet ist. Dies ist aber durch einfache konstruktive Maßnahmen zu gewährleisten. Damit kann auf sehr einfache Art und Weise mit einem einzigen Sicherungselement an der Frontseite des Gehäuses erreicht werden, dass - bei geeignet ausgestaltetem Sicherungselement - jegliche Art von Öffnen des Gehäuses dazu führt, dass das Sicherungselement zerstört wird. Damit ist das Sicherungselement gut erkennbar und gewährleistet gleichzeitig eine zuverlässige Anzeige für ein (meist unberechtigtes) Öffnen des Gehäuses.

Es sei darauf hingewiesen, dass die vorliegende Erfindung im Zusammenhang mit den verschiedensten in der Praxis gebräuchlichen Tragschienen Verwendung finden kann. Gemäß einer ganz besonders bevorzugten Ausgestaltung ist die Tragschiene jedoch eine Hutschiene und das erfindungsgemäße Gehäuse ein Hutschienengehäuse.

Vorzugsweise weist das Gehäuse in oder an der Montageseite (d.h. der Seite, die bei Montage auf der Tragschiene der Tragschiene zugewandt ist) ein Haltebereich auf. Eine Ausbildung in der Montageseite kann dadurch erreicht werden, dass eine Vertiefung in der Montageseite ausgebildet ist, in die die Tragschiene bei Montage des Gehäuses auf die Tragschiene eingreift. Vorzugsweise erstreckt sich dabei die Vertiefung über die gesamte Breite der Montageseite. Dabei kann in dem Haltebereich mindestens eine Haltenase ausgebildet sein, mit der die Tragschiene in dem Haltebereich gehalten wird. Bei Ausbildung des Haltebereichs an der Montageseite können an der Montageseite Stege, Stifte oder ähnlich geartete Erhebungen ausgebildet sein, die als Haltebereich fungieren können. Auch in diesem Fall würde die Tragschiene in den/die Bestandteil/e des Haltebereichs eingreifen. Zwar wäre bei Ausgestaltung des Haltebereichs an der Montageseite denkbar, dass die Tragschiene in mehr als lediglich einer Position relativ zu dem Gehäuse bei Montage des Gehäuses auf der Tragschiene angeordnet sein kann. Für die nachfolgenden Ausführungen wird jedoch davon ausgegangen, dass der Haltebereich stets so ausgebildet ist, dass lediglich eine Ausrichtung der Tragschiene relativ zu dem Gehäuse nach Montage des Gehäuses auf der Tragschiene möglich ist.

In einer besonders bevorzugten Ausgestaltung besteht das Gehäuse aus genau zwei Teilen. Diese beiden Gehäuseteile können auf die verschiedensten Arten ausgebildet sein. Wesentlich ist lediglich, dass die Stoßkante zwischen den beiden Gehäuseteilen zumindest teilweise entlang einer Seite des Gehäuses verläuft, die eine Frontseite im Sinne dieser Erfindung ist.

Gemäß einer besonders bevorzugten Ausgestaltung eines zweiteiligen Gehäuses sind die beiden Gehäuseteile symmetrisch zueinander aufgebaut. Dabei ist die Ausbildung verschiedener Symmetrieachsen oder -ebenen denkbar. Gemäß einer bevorzugten Ausgestaltung ist die Frontseite punktsymmetrisch zu einem Punkt im Sicherungsbereich ausgebildet. Damit ist das gesamte Gehäuse achssymmetrisch zu einer Symmetrieachse durch diesen Symmetriepunkt und senkrecht zur Frontseite ausgebildet. Bei dieser bevorzugten Ausgestaltung kann das Gehäuse spritzgusstechnisch besonders günstig hergestellt werden, da die Werkzeuge lediglich für die Herstellung einer Hälfte ausgebildet sein müssen. Dadurch können zwei weitgehend identische Teile zu einem Gesamtgehäuse zusammengefügt werden. Dies bedeutet auch, dass im Sicherungsbereich an beiden Gehäuseteilen jeweils eine Lasche ausgebildet ist, die in eine korrespondierende Ausnehmung an dem anderen Gehäuseteil eingreift. Dies bedeutet wiederum, dass eine besonders starke Verschwenkung der Laschen und Ausnehmungen relativ zueinander entsteht, wenn das Gehäuse durch Verschwenken der Gehäuseteile geöffnet wird.

Zum Erzielen eines möglichst starken Verschwenkens der Lasche/n relativ zu der/ den zugehörigen Ausnehmung/en weist die an der Oberfläche des Gehäuses sichtbare Stoßkante in dem Sicherungsbereich vorzugsweise einen wellenförmigen und/ oder gestuften Verlauf auf. Dabei verläuft vorzugsweise mindestens ein Teilbereich der Stoßkante orthogonal, schräg und/oder in sonstiger Form relativ zu dem Verlauf, den die Stoßkante ohne die Lasche sehr wahrscheinlich annehmen würde. Je stärker ausgeprägt dieser Verlauf ist und je kleiner die Strukturen sind, desto größer ist die relative Verschwenkung von Lasche und Ausnehmung bei Öffnen des Gehäuses durch Verschwenken der Gehäuseteile. Dadurch ergibt sich eine besonders große Scherkraft auf ein im Sicherungsbereich angebrachtes Sicherungselement.

Allerdings sollten die Strukturen groß genug sein, dass ausreichende Stabilität gegeben ist und eine Lasche nicht bei Öffnen des Gehäuses abbricht. Entsprechende Dimensionierungsvorschriften sind einem Fachmann geläufig. Neben einem besonders ausgeprägten relativen Verschwenken zwischen Lasche und Ausnehmung bietet ein gestufter und/oder wellenförmiger Verlauf der Stoßkante den weiteren Vorteil, dass ein Zerschneiden eines im Sicherungsbereich angebrachten Siegeletiketts, beispielsweise durch eine Rasierklinge, deutlich erschwert wird. Je unstetiger der an der Oberfläche des Gehäuses sichtbare Verlauf der Stoßkante im Sicherungsbereich ist, desto schwieriger ist es, einen sauberen und nicht-erkennbaren Schnitt an dem Siegeletikett zu platzieren. Dies erhöht weiterhin die Erkennbarkeit eines Öffnens des Gehäuses.

Es sei darauf hingewiesen, dass der Begriff "gestufter Verlauf" sich nicht lediglich auf rechtwinklige Verläufe der Stoßkante bezieht. Vielmehr bedeutet dies, dass die Stoßkante nicht-linear ist. Beispielhaft sei auf einen trapez-, dreieck- oder sägezahnförmigen Verlauf hingewiesen.

In einer bevorzugten Ausgestaltung des Sicherungsbereichs ist dieser als planer Bereich an der Oberfläche der Frontseite und zur Aufnahme eines Siegeletiketts ausgebildet. Vorzugsweise wird dieser planare Bereich lediglich durch die Stoßkante unterbrochen. Durch Ausbildung des Sicherungsbereichs als planarer Bereich kann eine große Haftfläche für das Siegeletikett geschaffen werden und gleichzeitig durch Ausbildung von Lasche und Ausnehmung eine ausreichende Scherkraft bei Verschwenken der Gehäuseteile relativ zueinander erzielt werden. Siegeletiketten sind in der Praxis weit verbreitet und bestehen aus Papier oder einem dünnen Kunststoff, wie Polystyrol oder einer Polyesterfolie. Es sind auch Siegeletikette bekannt, die aus zwei oder mehr Folien bestehen und deren Erscheinungsbild sich bei einer Manipulation ändert. So ist beispielsweise nach einer Manipulation ein Schriftzug nicht mehr erkennbar. Einige bekannte Siegeletikette hinterlassen Rückstände auf der Oberfläche des Gehäuses, wenn das Siegetikett abgelöst wird. Durch gute Haftmöglichkeit des Siegeletiketts auf dem Gehäuse und ein ausgeprägtes Verschwenken von Lasche und Ausnehmung relativ zueinander wird das Siegeletikett bei Verschwenken der Gehäuseteile sicher beschädigt.

In einer bevorzugten Weiterbildung ist der planare Bereich in einer Siegeltasche in der Oberfläche ausgebildet. Dies bedeutet, dass ein prinzipiell beliebig geformter Randbereich eine Vertiefung in der Oberfläche bildet. Dies kann beispielsweise durch eine kreisrunde oder rechteckförmige Vertiefung gebildet sein, deren Ecken eventuell abgerundet sind. Vorzugsweise sind dabei Siegeltasche und Siegeletikett derart aufeinander abgestimmt, dass das Siegeletikett in angebrachtem Zustand die Siegeltasche weitgehend ausfüllt. Dabei kann die Lasche bzw. - bei Ausbildung mehrerer Laschen im Sicherungsbereich - die Laschen derart dimensioniert sein, dass die Lasche/eine der Laschen maximal 50% der Fläche der Siegeltasche einnimmt. Dies trägt weiterhin dazu bei, dass bei Öffnen des Gehäuses ausreichende Kräfte auf das Sicherungselement einwirken, so dass dieses sicher zerstört wird.

In einer alternativen oder zusätzlich einsetzbaren Ausgestaltung des Sicherungsbereichs kann dieser dazu ausgebildet sein, eine Plombe als Sicherungselement aufzunehmen. Dies kann dadurch entstehen, dass in dem Sicherungsbereich nahe der Stoßkante Laschen ausgebildet sind, durch die die Plombe geführt werden kann. Dabei ist in jedem der an dem Sicherungsbereich angrenzenden Gehäuseteile jeweils eine Lasche vorgesehen, so dass die Plombe beide im Sicherungsbereich angrenzenden Gehäuseteile verbinden kann. Eine Lasche im Sinne dieser Ausgestaltung ist jede Ausbildung einer Durchführung, die in der Lage ist, eine Plombe aufzunehmen und gleichzeitig gewissen Kräften bei Öffnen des Gehäuses standzuhalten. Gebräuchliche Plomben bestehen aus Metall oder Kunststoff. Bei vielen aus der Praxis bekannten Ausgestaltungen muss eine Plombe erst entfernt, beispielsweise durchschnitten, werden, bevor das Gehäuse geöffnet werden kann.

Prinzipiell können Montageseite und Frontseite relativ beliebig zueinander angeordnet sein. So können beispielsweise Frontseite und Montageseite senkrecht zueinander stehen. In einer bevorzugten Ausgestaltung des Gehäuses liegen Front- und Montageseite jedoch an gegenüberliegenden Seiten des Gehäuses. Eine derartige Ausgestaltung ist beispielsweise bei dem bereits angeführten Hutschienengehäuse üblich. Front- und Montageseite können dabei wiederum in einem relativ beliebigen Winkel zueinander orientiert sein. Vorzugsweise sind jedoch Montageseite und Frontseite parallel oder zumindest annähernd parallel zueinander angeordnet.

Zur Verbesserung des Zusammenhalts der einzelnen Gehäuseteile im zusammengefügten Zustand können im Bereich der Stoßkante eine oder mehrere Rastnasen ausgebildet sein. Jede Rastnase würde in eine korrespondierende Vertiefung oder einen korrespondierenden Durchbruch in dem Gehäuseteil eingreifen, der im Bereich der Stoßkante an den die Rastnase tragenden Gehäuseteil angrenzt. Derartige Rastverbindungen (auch als Schnappverschlüsse bezeichnet) sind aus der Praxis bekannt.

In einer bevorzugten Verwendung einer Rastnase ist diese im Bereich der Lasche im Sicherungsbereich angeordnet. Dabei kann die Rastnase an der Lasche ausgebildet sein oder in der mit der Lasche korrespondierenden Ausnehmung in dem angrenzenden Gehäuseteil. Durch diese Ausgestaltung kann das Ziel der Erfindung noch weiter verbessert werden.

Zur Aufnahme einer oder mehrerer Elektrobaugruppen können im Inneren des Gehäuses Führungsschienen ausgebildet sein. Diese Führungsschienen können dazu ausgestaltet sein, auf Platinen ausgebildete Elektrobaugruppen aufzunehmen und zu halten. Die Führungsschienen können dabei weiter dazu beitragen, dass nur gewisse Öffenbewegungen des Gehäuses, beispielsweise nur parallel zu den Führungsschienen, möglich sind. Dadurch kann die Sicherheit und die Stabilität des Gehäuses weiter verbessert werden.

Das Gehäuse kann zur Aufnahme von Platinen in verschiedenster Orientierung ausgebildet sein. In einer bevorzugten Ausgestaltung ist das Gehäuse zur Aufnahme von parallel zur Frontseite angeordneten Platinen ausgebildet. Allerdings kann das Gehäuse auch zur Aufnahme von senkrecht zur Frontseite angeordneten Platinen ausgebildet sein, wodurch Anschlüsse oder Anzeigen besser an die Frontseite gebracht werden kann. Es ist auch möglich, dass beide Ausgestaltungen, d.h. eine parallel orientierte Platine und eine senkrecht zur Frontseite orientierte Platine kombiniert werden können. Die beiden Platinen können dann durch Steckverbindungen oder Lötverbindungen miteinander verbunden sein. Denkbar ist auch die Verwendung sogenannter Starrflex-Platinen, die aus starren und flexiblen Teilen bestehen. Die starren Teile sind durch übliche Platinen gebildet, beispielsweise auf Epoxidbasis. Die flexiblen Teile entstehen durch Trägerfolien, die dauerhaft mit dem/den starren Platinenteil/en verbunden ist. Auf diese Weise können Leiterbahnen über ein starres Platinenteil hinausgeführt werden können.

Insbesondere bei einem zweiteiligen Gehäuse kann das Gehäuse eine Fügerichtung aufweisen, in der zwei Gehäuseteile zusammengefügt werden können. Dabei ist die Fügerichtung vorzugsweise parallel zur Frontseite ausgebildet. Bei Ausbildung eines Haltebereichs in oder an der Montageseite ist die Fügerichtung vorzugsweise ferner senkrecht zu dem Haltebereich ausgebildet.

Vorzugsweise ist das Gehäuse als geschlossenes Gehäuse aufgebaut. Dabei weist das Gehäuse vorzugsweise lediglich Lüftungsschlitze auf, die sich auch derart ausgestalten lassen, dass kein direkter Zugriff auf die Elektrobaugruppe innerhalb des Gehäuses möglich ist. Entsprechende Ausführungen von Lüftungsschlitzen sind aus der Praxis bekannt. Das Gehäuse kann auch Durchführungen für Anschlüsse einer in dem Gehäuse angeordneten Elektrobaugruppe aufweisen. Denkbar wäre beispielsweise eine rechteckige Durchführung für eine RJ45-Buchse, an die ein Ethernet-Kabel angeschlossen werden kann. Es können in dem Gehäuse auch Durchführungen für Sichtbereiche ausgebildet sein, durch die Anzeigen der Elektrobaugruppe, beispielsweise in Form von LEDs (lichtimitierende Dioden), von außerhalb des Gehäuses erkennbar werden. Auf diese Weise kann durch das Gehäuse hindurch ein Status nach außen gemeldet werden, beispielsweise grün für einen normalen Betrieb. Dadurch ist ein sicherer Betrieb der in dem Gehäuse enthaltenen Elektrobaugruppe möglich, wobei gleichzeitig eine Manipulation der Elektrobaugruppe auch durch Öffnungen oder Durchführungen an dem Gehäuse verhindert werden kann.

Das Gehäuse kann mit einem Sicherungselement zu einer Gehäuseanordnung kombiniert werden. Das Sicherungselement ist dabei vorzugsweise als Siegeletikett ausgebildet. Das Siegeletikett kann aus den verschiedensten aus der Praxis bekannten Materialien, beispielsweise Papier oder einem Kunststoff, bestehen und ist im Submillimeterbereich dick. Gebräuchlich sind Dicken von 0,1 bis 0,5 mm. Es sind ein- oder mehrschichtige Siegeletikette verwendbar.

Auf dem Siegeletikett können mit thermoselektiver Tinte taktil erfassbare Strukturen aufgebracht sein, wie beispielsweise Braille-Zeichen oder Reliefs. Zudem kann das Siegeletikett über ein Hologramm verfügen. Denkbar wären auch feine Strukturen auf dem Siegeletikett, wie sie bei Geldscheinen gebräuchlich sind, um die Kopierbarkeit des Siegeletiketts weiter zu erschweren. Andere Sicherheitsmerkmale können durch Strukturen gebildet sein, die beispielsweise ultraviolettes Licht auf besondere Weise reflektieren oder die in Abhängigkeit der Temperatur ihre Farbe ändern. Bei letzterer Ausgestaltung kann beispielsweise durch Reibung an dem Siegeletikett ein Farbumschlag erzeugt werden, wodurch ohne jegliche Hilfsmittel die Echtheit des Siegeletiketts verifiziert werden kann. Die voranstehende nicht abschließende Auflistung zeigt, wie universell Sicherheitsmerkmale der Siegeletikette ausgestaltet sein können. Wenn das Gehäuse zur Aufnahme eines Smart-Meter-Gateways nach FNN MS 2020 ausgebildet ist, müsste das Siegeletikett die Anforderungen an das "geeignete Siegel" gemäß Absatz 6.2 des Dokuments BSI TR03109-1 erfüllen.

In einer alternativen Ausgestaltung kann eine Gehäuseanordnung auch unter Verwendung eines anderen Sicherungselements gebildet sein. In dem Sicherungsbereich, der bei der zuvor beschriebenen Ausgestaltung das Siegeletikett aufnimmt, kann bei dieser Ausgestaltung mittels eines Ultraschallstempels ein Relief in die Oberfläche des Gehäuses eingeprägt werden. In diesem Fall wird der Ultraschallstempel, der an seiner Prägeoberfläche eine dreidimensionale Struktur aufweist, mit seiner Prägeoberfläche im Sicherungsbereich auf das Gehäuse gedrückt und zu Ultraschallschwingungen veranlasst. Dadurch wird die dreidimensionale Struktur der Prägeoberfläche in den Sicherungsbereich eingeprägt und die aneinanderstoßenden Gehäuseteile miteinander verschweißt. Da die Verschweißung lediglich oberflächlich erfolgt, können die Gehäuseteile wieder voneinander getrennt werden. Das Trennen hinterlässt allerdings sichtbare Spuren an dem Sicherungselement, so dass auch bei dieser Ausgestaltung ein Öffnen des Gehäuses erkennbar ist.

Es gibt nun verschiedene Möglichkeiten, die Lehre der vorliegenden Erfindung in vorteilhafter Weise auszugestalten und weiterzubilden. Dazu ist einerseits auf die dem Anspruch 1 nachgeordneten Ansprüche und andererseits auf die nachfolgende Erläuterung bevorzugter Ausführungsbeispiele der Erfindung anhand der Zeichnung zu verweisen. In Verbindung mit der Erläuterung der bevorzugten Ausführungsbeispiele der Erfindung anhand der Zeichnung werden auch im Allgemeinen bevorzugte Ausgestaltungen und Weiterbildungen der Lehre erläutert. In der Zeichnung zeigen
- Fig. 1: eine typische Einbausituation eines erfindungsgemäße Gehäuses,
- Fig. 2: eine Draufsicht eines erfindungsgemäßen Gehäuses bestehend aus zwei symmetrischen Gehäuseteilen,
- Fig. 3: eine Draufsicht eines weiteren erfindungsgemäßen Gehäuses mit Durchführungen für Leuchtanzeigen und eine RJ45-Buchse,
- Fig. 4: eine Draufsicht der Gehäuses nach Fig. 3, wobei ein Siegeletikett auf den Sicherungsbereich angebracht ist,
- Fig. 5: eine Ansicht des Gehäuses nach Fig. 3 auf die Montageseite,
- Fig. 6: eine Schrägansicht des Gehäuses nach Fig. 3 mit angebrachtem Siegeletikett,
- Fig. 7: eine Seitenansicht eines erfindungsgemäßen zweiteiligen Gehäuses, das durch Verschwenken der beiden Gehäuseteile entlang der Stoßkante an der Frontseite geöffnet wird,
- Fig. 8: eine Detailansicht des Gehäuses nach Fig. 7,
- Fig. 9: ein Querschnitt durch den Sicherungsbereich zur Verdeutlichung der Anbringung eines Siegeletiketts an der Oberfläche (Fig. 9A) und in einer Siegeltasche (Fig. 9B),
- Fig. 10: eine Draufsicht eines erfindungsgemäßen Gehäuses, bei dem der Sicherungsbereich in einer Siegeltasche ausgebildet ist,
- Fig. 11: eine Schrägansicht eines längs der Fügerichtung geöffneten erfindungsgemäßen Gehäuses,
- Fig. 12: eine Draufsicht eines Gehäuseteils zur Verdeutlichung der spritzgusstechnischen Herstellung des Gehäuses,
- Fig. 13: mehrere Ansichten eines erfindungsgemäßen Gehäuses mit einer Plombe als Sicherungselement, wobei die Laschen der Übersichtlichkeit wegen nicht dargestellt sind,
- Fig. 14: ein Ausschnitt einer Elektrobaugruppe auf einer horizontalen und vertikalen Platine, die in dem erfindungsgemäßen Gehäuse angeordnet sein kann,
- Fig. 15: eine Draufsicht eines Teils eines erfindungsgemäßen Gehäuses mit in dem Gehäuse angeordneten vertikalen Platinen und
- Fig. 16: eine Draufsicht auf ein Gehäuse mit einem aus dem Zentrum der Frontseite verschobenen Sicherungsbereich.

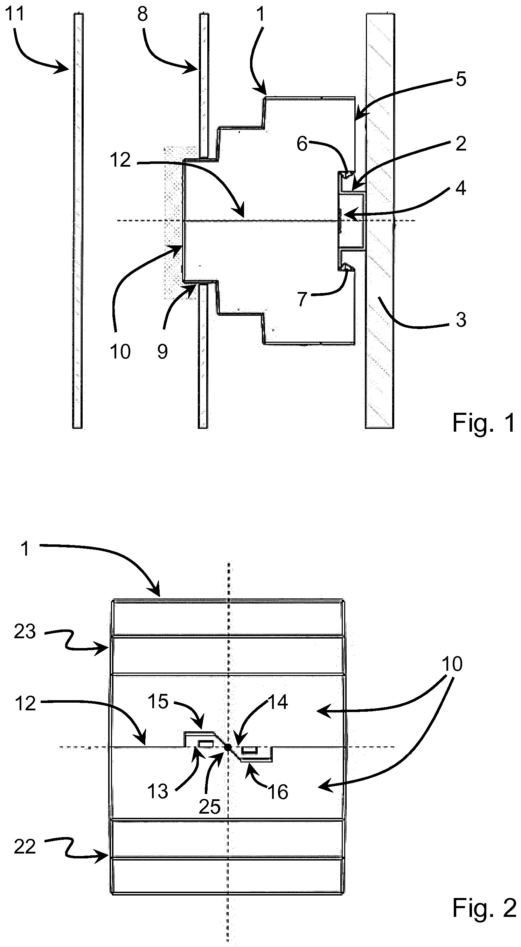

Fig. 1 zeigt eine typische Einbausituation eines erfindungsgemäßen Gehäuses 1. Das Gehäuse ist auf einer Tragschiene 2 montiert, die wiederum an einer Wand 3 angebracht ist. Das Gehäuse 1 weist einen gestuften Aufbau auf, wobei die Stufen mit zunehmendem Abstand zur Wand 3 schmäler werden. Die Tragschiene greift in einen Haltebereich 4 ein, der als Vertiefung in der Montageseite 5 ausgebildet ist und sich über die gesamte Breite der Montageseite 5 erstreckt. Zur Fixierung der Tragschiene 2 sind in dem Haltebereich 4 Arretierungsnasen 6 und 7 vorgesehen, die das Gehäuse 1 sicher auf der Tragschiene 2 halten und gleichzeitig eine Entnehmbarkeit des Gehäuses von der Tragschiene ermöglichen. Gemäß dargestelltem Ausführungsbeispiel ist die Montageseite 5 im montierten Zustand des Gehäuses parallel zur Wand 3 angeordnet.

Parallel zu der Wand 3 ist eine Berührungsschutzabdeckung 8 angeordnet, die den Raum zwischen Berührungsschutzabdeckung 8 und Wand 3 nach außen hin (also die der Wand 3 abgewandte Seite der Berührungsschutzabdeckung 8) abschirmt. Auf diese Weise müssen in dem Bereich zwischen Berührungsschutzabdeckung 8 und Wand 3 nicht alle Kontakte isoliert sein, was insbesondere Elektrounterverteilern enorme Vorteile mit sich bringt. Die Berührungsschutzabdeckung 8 weist mindestens eine Durchführung 9 auf, durch die ein Teil des Gehäuses 1 durchgeführt werden kann. Dadurch bleibt eine Frontseite 10 des Gehäuses 1 sichtbar, auch wenn das Gehäuse 1 auf der Tragschiene 2 montiert und die Berührungsschutzabdeckung 8 angebracht ist. Es ist erkennbar, dass die Frontseite in diesem Ausführungsbeispiel parallel zur Montageseite angeordnet ist. Gleichzeitig sind aber nicht zwangsläufig alle Teile des Gehäuses, die parallel zur Montageseite angeordnet sind, Frontseite im Sinne der vorliegenden Erfindung. In dem Ausführungsbeispiels nach Fig. 1 bildet lediglich die am weitesten von der Wand 3 entfernte Stufe die Frontseite.

Die gesamte Anordnung ist durch eine Türe 11 abgeschlossen, die einen weiteren Schutz der dahinter liegenden Elemente bietet. Die in Fig. 1 dargestellte Einbausituation für ein erfindungsgemäßes Gehäuses ist für Elektroverteiler auf Basis von Hutschienen weit verbreitet.

In Fig. 2 ist eine Draufsicht eines erfindungsgemäßen Gehäuses dargestellt. Wenn von den an der Frontseite ausgebildeten Laschen abgesehen wird, weist das Gehäuse zwei "Symmetrieebenen" auf, die mit gestrichelter Linie in Fig. 2 eingezeichnet sind. Eine erste "Symmetrieebenen" verläuft längst der Stoßkante 12, entlang der das Gehäuse trennbar ist, eine zweite "Symmetrieebene" verläuft senkrecht zu der ersten "Symmetrieebene". Wenn die Laschen an der Frontseite für eine Symmetriebetrachtung mit berücksichtigt werden, so ist die Frontseite punktsymmetrisch zu dem Symmetriepunkt 25. Das Gehäuse ist insgesamt achssymmetrisch zu einer Symmetrieachse, die durch den Symmetriepunkt 25 geht und senkrecht zur Zeichenebene angeordnet ist.

In der Mitte der Frontseite 10 ist ein Bereich ausgebildet, der zur Anbringung eines Sicherungselements ausgebildet ist. In diesem, nachfolgend als Sicherungsbereich bezeichneten Bereich ist an der Stoßkante eine Lasche 13 bzw. 14 ausgebildet, die in korrespondierende Ausnehmungen 15 bzw. 16 in dem gegenüberliegenden Gehäuseteil eingreift. Die im Bereich der Laschen 13 und 14 erkennbaren Rechtecke sind Durchbrüche 19, in die Rastnasen eingreifen. Hierauf wird nachfolgend noch genauer eingegangen. Die an der Oberfläche des Gehäuses sichtbare Stoßkante erhält durch die Laschen 13 und 14 sowie die korrespondierenden Ausnehmungen 15 und 16 einen gestuften Verlauf. Es ist auch zu erkennen, dass der Sicherungsbereich durch einen im Wesentlichen planaren Bereich gebildet ist. Lediglich die Stoßkante und Unterbrechungen im Bereich der Ausnehmungen unterbrechen diesen planaren Bereich.

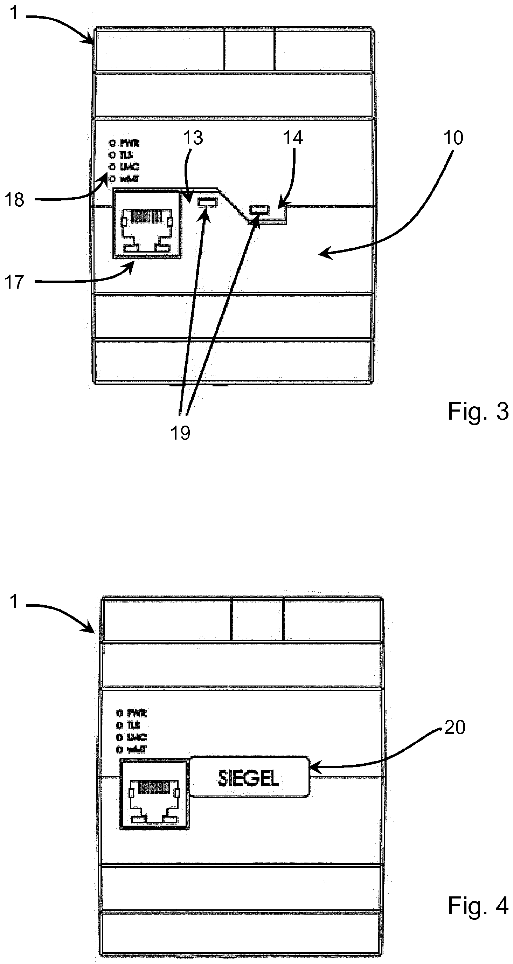

Fig. 3 zeigt eine Draufsicht eines weiteren erfindungsgemäßen Gehäuses, das weitgehend dem Gehäuse nach Fig. 2 entspricht. Allerdings sind in der Frontseite 10 des Gehäuses einige Durchführungen zu erkennen, durch die Elemente der in dem Gehäuse angeordneten Elektrobaugruppe sichtbar sind. Durch eine dieser Durchführungen ist ein Anschluss 17 zugänglich, der in Form eines RJ45-Buchse ausgestaltet ist. Durch weitere Durchführungen sind Leuchtanzeigen erkennbar, die verschiedenen Statusinformationen der in dem Gehäuse enthaltenen Elektrobaugruppe anzeigen. Des Weiteren sei nochmals auf die Durchbrüche 19 in den Laschen 13 und 14 hingewiesen.

Fig. 4 zeigt nochmals das Gehäuse nach Fig. 3. Allerdings ist in dem Sicherungsbereich ein Siegeletikett 20 aufgeklebt, das die beiden Laschen 13 und 14 vollständig überdeckt. Es ist auch zu erkennen, dass das Siegeletikett 20 über den Bereich der Laschen 13 und 14 auf der rechten Seite hinausgeht. Gleichzeitig überdeckt das Siegeletikett die Stoßkante, die Ausnehmungen 15 und 16 und die darin eingreifenden Rastnasen, wodurch deren Position im Sicherungsbereich verschleiert wird. Auf diese Weise ist eine Manipulation erschwert. Da nicht erkennbar ist, wo die Stoßkante angeordnet sind, ist das saubere Durchtrennen des Siegeletiketts entlang der Stoßkante mit einem scharfen Messer oder einer Rasierklinge praktisch nicht möglich.

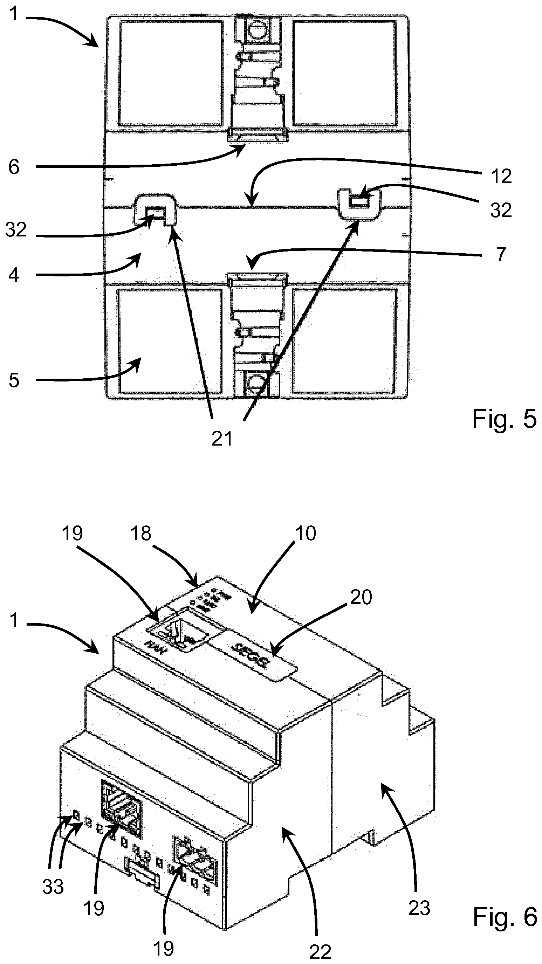

Fig. 5 zeigt eine Ansicht des erfindungsgemäßen Gehäuses mit Blick auf die Montageseite 5 und den Haltebereich 4. In dieser Ansicht ist auch der Mechanismus für die Arretierungsnasen 6 und 7 zu erkennen, mit denen die Tragschiene 2 bei Montage des Gehäuses auf der Tragschiene 2 eingeklemmt wird. Auch im unteren Bereich des Gehäuses ist erkennbar, dass das Gehäuse punktsymmetrisch aufgebaut ist. An der Stoßkante 12 sind zwei Schnappverschlüsse 21 vorgesehen, bei denen eine Rastnase 32 in dem einen Gehäuseteil in eine Öse an dem anderen Gehäuseteil eingreift.

In Fig. 6 ist eine Schrägansicht des Gehäuses nach Fig. 4 dargestellt. Auch hier sind das Siegeletikett 20 sowie die Leuchtanzeigen 18 und der Durchbruch 19 für eine RJ45-Buchse 17 erkennbar. Ergänzend sind im unteren vorderen Bereich weitere Durchbrüche 19 vorgesehen, an die Elemente der in dem Gehäuse enthaltenen Elektrobaugruppe angeschlossen werden können. Der linke Anschluss ist dabei wiederum eine RJ45-Buchse, der rechte Anschluss dient als Anschluss einer Stromversorgung für die in dem Gehäuse enthaltene Elektrobaugruppe. Ferner sind in dem dargestellten Gehäuse Lüftungslöcher 33 zu erkennen, über die Abwärme aus dem Gehäuseinneren nach außen dringen kann. In dieser Ansicht ist ferner nochmals die gestufte Gehäuseform deutlich zu erkennen.

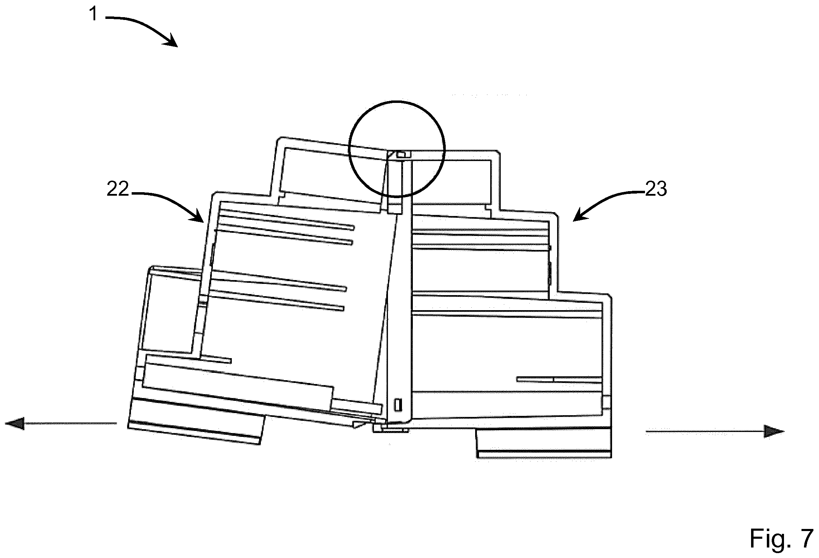

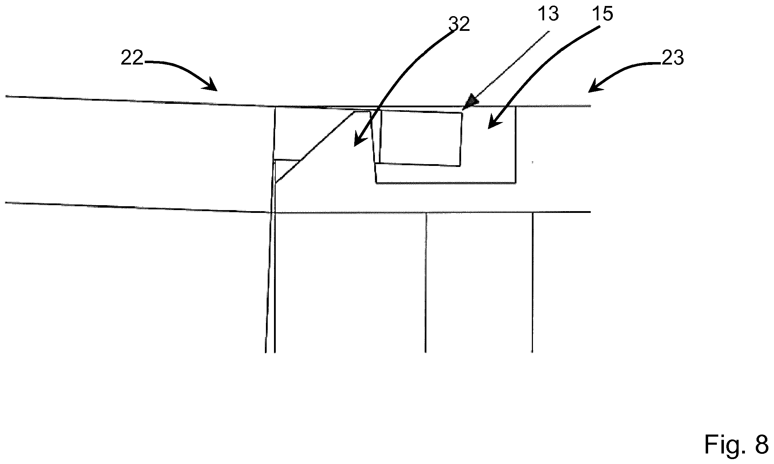

Mit Bezug auf die Fig. 7 und 8 soll die Wechselwirkung zwischen den Laschen und den korrespondierenden Außnehmungen im Sicherungsbereich näher erläutert werden. Fig. 7 zeigt eine Darstellung eines Gehäuses 1, das teilweise geöffnet ist, nämlich durch Verschwenken der Gehäuseteile 22 und 23 relativ zueinander und entlang der Stoßkante 12 an der Frontseite 10. In diesem Fall sind die Schnappverbindungen 21 an der Montageseite 5 des Gehäuses 1 geöffnet worden und es wird versucht, das Gehäuse aufzuklappen. Die Bewegungsrichtungen der Gehäuseteile sind in Fig. 7 mit Pfeilen nach links und rechts dargestellt.

Fig. 8 zeigt eine Vergrößerung des in Fig. 7 mit einem Kreis gekennzeichneten Bereichs. Durch Verschwenken des Gehäuseteils 22 und 23 relativ zueinander bewegt sich die Lasche 13 in der korrespondierenden Ausnehmung 15 nach unten. Mit Blick auf die Fig. 2 und 4 wird deutlich, dass es dadurch zu einer Bewegung im Sicherungsbereich kommt: Die Laschen 13 und 14 verschieben sich gegeneinander (im Bereich des Symmetriepunkts 25), wodurch Scherkräfte auf ein in dem Sicherungsbereich angebrachtes Sicherungselement entstehen. Bei geeigneter Ausgestaltung des Siegeletiketts können die Scherkräfte das Siegeletikett beschädigen, z.B. das Siegeletikett reißt oder ein Sicherheitsmerkmale des Siegeletiketts wird ausgelöst. Geeignete Ausgestaltung bedeutet, dass das Siegeletikett über ausreichend Haftkraft verfügt, so dass sich das Siegeletikett nicht von der Lasche oder einem anderen Teil des Sicherungsbereichs löst. Gleichzeitig muss das Siegeletikett ausreichend stabil sein, dass das Siegeletikett bei normaler Handhabung des Gehäuses nicht zerreißt. Andererseits muss das Siegeletikett "spröde" genug sein, damit die Scherkräfte, die beim Aufklappen des Gehäuses entsprechend Fig. 7 bzw. 8 entstehen, zu einer Zerstörung des Siegeletiketts führen. Entsprechende Siegeletikette sind aus dem Stand der Technik bekannt. Es ist zu erkennen, dass durch die erfindungsgemäße Ausgestaltung von Lasche und korrespondierender Ausnehmung jegliche mögliche Öffnung des Gehäuses eine Zerstörung des Siegeletiketts zur Folge hat. Dadurch ist eine Möglichkeit gegeben, mit der ein unberechtigtes Öffnen des Gehäuses erkannt werden kann.

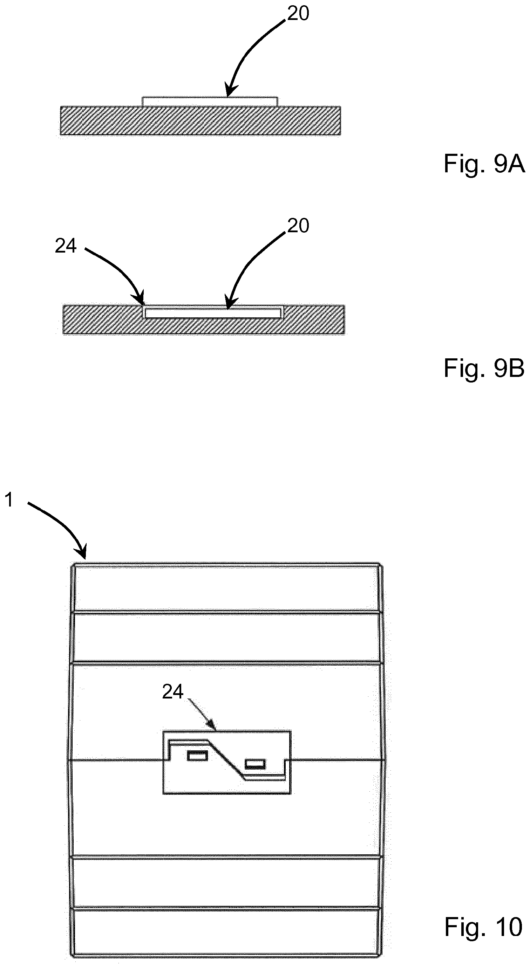

In den bisherigen Figuren war der Sicherungsbereich an der Oberfläche an der Frontseite ausgebildet. Eine entsprechende Anbringung ist in Fig. 9A nochmals im Querschnitt dargestellt. In der Ausführung nach Fig. 9B ist hingegen der Sicherungsbereich in einer Siegeltasche 24 ausgebildet. Die Siegeltasche 24 ist durch eine Vertiefung in der Oberfläche der Frontseite 10 gebildet. Der Sicherungsbereich ist damit ein relativ zur Oberfläche der Frontseite geringfügig tiefer gelegtes Segment der Oberfläche.

Fig. 10 zeigt eine Draufsicht eines Gehäuses mit einer Siegeltasche. In dieser Ausgestaltung ist die Siegeltasche rechteckförmig ausgebildet und das Siegeletikett (nicht eingezeichnet) wird in der Oberfläche versenkt. Auf diese Weise wird das Ablösen des Siegeletiketts beispielsweise mit einem Rasiermesser, das entlang der Frontseite 10 geführt wird, nahezu unmöglich.

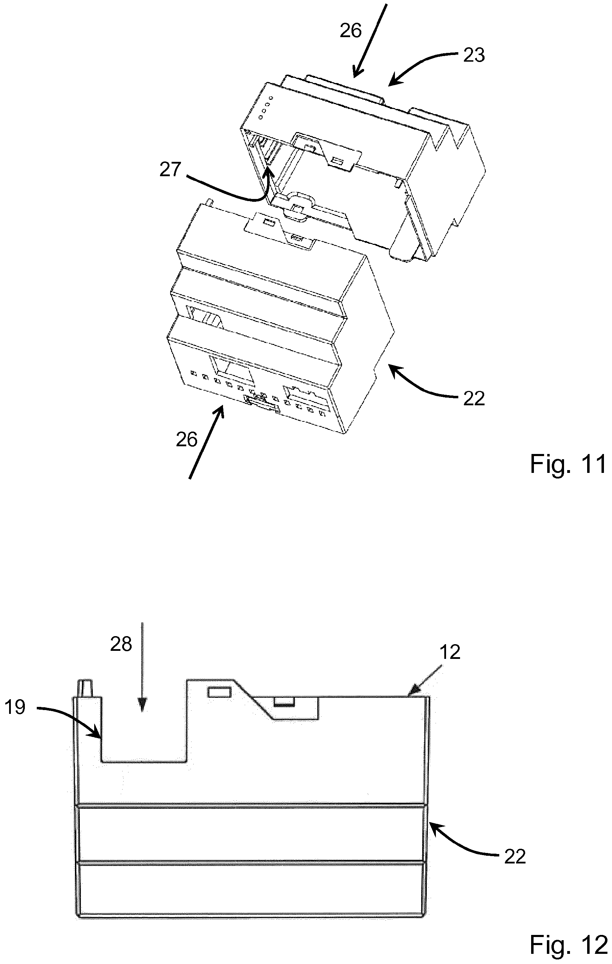

Fig. 11 zeigt nochmals ein geöffnetes Gehäuse in Schrägansicht, wobei das Gehäuse längs seiner Fügerichtung 26 geöffnet ist. Innerhalb des Gehäuses 1 sind Führungsschienen 27 erkennbar, in die eine auf einer Platine aufgebaute Elektrobaugruppe eingeschoben werden kann.

Anhand von Fig. 12 soll die Werkzeugrichtung 28 bei einer spritzgusstechnischen Herstellung des Gehäuses verdeutlicht werden. Es bietet sich an, Durchbrüche 19 für Anschlüsse und Steckverbinder entlang der Stoßkante 12 vorzusehen, da an dieser Stelle das Spritzgusswerkzeug in Werkzeugrichtung 28 den Innenteil des Gehäuses bestimmt und prinzipiell kein Werkzeug aus einer anderen Richtung notwendig ist. Wenn die Gehäuse - wie mit Bezug auf Fig. 2 ausgeführt - achssymmetrisch aufgebaut sind, kann derselbe Spritzgusswerkzeugkern für beide Gehäuseteile verwendet werden.

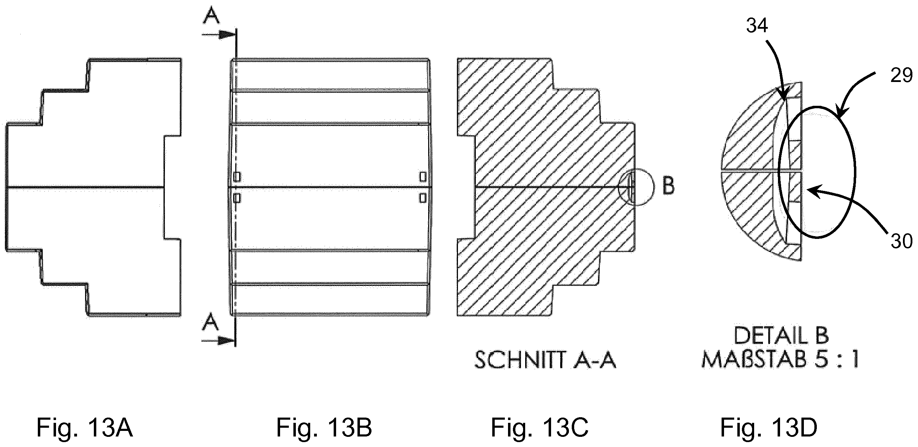

Fig. 13 zeigt verschiedene Ansichten eines weiteren Ausführungsbeispiels, bei dem als Sicherungselement eine Plombe 29 verwendet ist. Fig. 13A zeigt eine Seitenansicht des Gehäuses. Fig. 13B zeigt eine Draufsicht. In Fig. 13C ist ein Schnitt längs der Schnittkante A - A aus Fig. 13B zu entnehmen. Fig. 13D stellt eine Vergrößerung eines Details dar, das dem Inhalt des Kreises B in Fig. 13C entspricht. Es ist an beiden Seiten des Gehäuses jeweils ein Sicherungsbereich ausgebildet. In den beiden angrenzenden Gehäuseteilen sind Laschen 30 ausgebildet, in die eine Plombe 29 eingeführt werden kann. Bei der in Fig. 13 dargestellten Ausgestaltung wird das Einführen der Plombe 29 in die Lasche 30 durch eine Abschrägung 34 erleichtert. Der Übersichtlichkeit wegen ist keine Lasche mit korrespondierender Ausnehmung eingezeichnet. Es ist möglich, dass zusätzlich ein Siegeletikett entsprechend den vorgenannten Ausführungsbeispielen vorhanden ist.

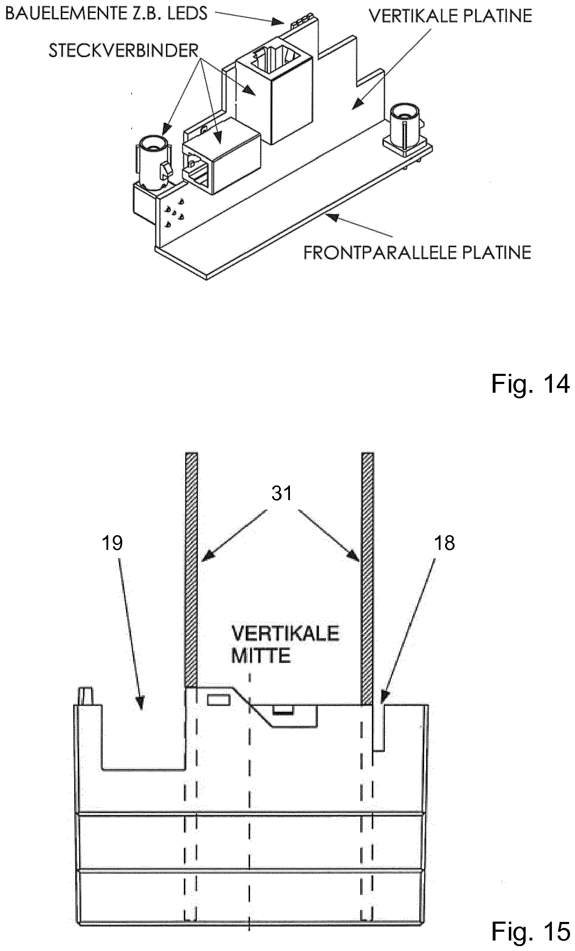

Fig. 14 und 15 zeigen verschiedene Varianten Platinen, auf denen Elektrobaugruppen innerhalb des erfindungsgemäßen Gehäuses aufgebaut sein können. Es ist möglich vertikale (also senkrecht zur Frontseite) und/oder frontparallele Platinen (also parallel zur Frontseite) zu verwenden. Fig. 14 zeigt eine Ausgestaltung einer Elektrobaugruppe, die aus einer Kombination aus frontparalleler Platine und vertikaler Platine aufgebaut ist. Des Weiteren ist an der Elektrobaugruppe eine Reihe von verschiedenen Anschlüsse zu erkennen. In Fig. 15 ist ein Gehäuseteil zu erkennen, in deren Inneren Führungsschienen für zwei vertikale Platinen 31 ausgebildet sind. Der Gehäuseteil weist Durchbrüche 19 für Anschlüsse sowie für Leuchtanzeigen 18 auf. Je nach dem Toleranzgebilde aus Gehäuse und Platine kann dem Aufklappen des Gehäuses durch Verschwenken der Gehäuseteile relativ zueinander entgegengewirkt werden, indem wenig Spiel zwischen Gehäuse und Platine belassen ist. Da die Platinen im Gehäuse gelagert und durch Führungsschienen gehalten werden, erfahren sie bei horizontaler Anordnung Verbiegung, bei vertikaler Anordnung hauptsächlich stauchende Kräfte.

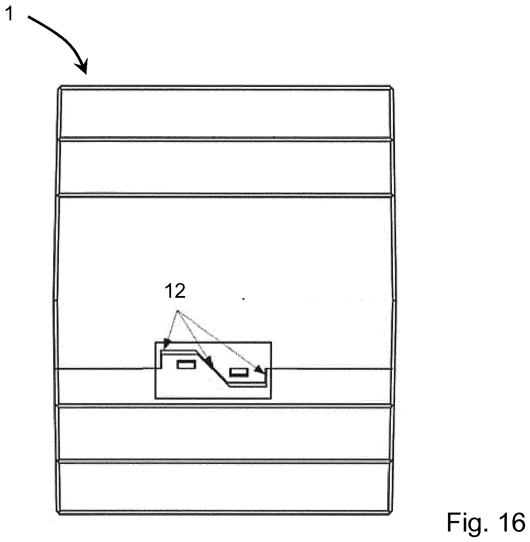

Fig. 16 zeigt ein weiteres Ausführungsbeispiel eines erfindungsgemäßen Gehäuses, bei dem der Sicherungsbereich aus der Mitte der Frontseite herausgeschoben ist. Im Übrigen verläuft aber auch hier die Stoßkante nicht-linear, sondern ist gestuft.

Hinsichtlich weiterer vorteilhafter Ausgestaltungen des erfindungsgemäßen Gehäuses bzw. der erfindungsgemäßen Gehäuseanordnung wird zur Vermeidung von Wiederholungen auf den allgemeinen Teil der Beschreibung sowie auf die beigefügten Ansprüche verwiesen.

Schließlich sei ausdrücklich darauf hingewiesen, dass die voranstehend beschriebenen Ausführungsbeispiele des erfindungsgemäßen Gehäuses bzw. der erfindungsgemäßen Gehäuseanordnung lediglich zur Erörterung der beanspruchten Lehre dienen, diese jedoch nicht auf die Ausführungsbeispiele einschränken.

### Bezugszeichenliste

- 1: Gehäuse
- 2: Tragschiene
- 3: Wand
- 4: Haltebereich
- 5: Montageseite
- 6: Arretierungsnase
- 7: Arretierungsnase
- 8: Berührungsschutzabdeckung
- 9: Durchführung (in Abdeckung 8)
- 10: Frontseite
- 11: Türe
- 12: Stoßkante
- 13: Lasche
- 14: Lasche
- 15: Ausnehmung
- 16: Ausnehmung
- 17: Anschluss
- 18: Leuchtanzeigen
- 19: Durchbrüche
- 20: Siegeletikett
- 21: Schnappverbindung
- 22: Gehäuseteil
- 23: Gehäusesteil
- 24: Siegeltasche
- 25: Symmetriepunkt
- 26: Fügerichtung
- 27: Führungsschiene
- 28: Werkzeugrichtung
- 29: Plombe
- 30: Lasche (für Plombe)
- 31: Platinen
- 32: Rastnase
- 33: Lüftungslöcher
- 34: Abschrägung

## Patentansprüche

1. Gehäuse für Elektrobaugruppen zur Montage auf einer Tragschiene, wobei das Gehäuse (1) aus mindestens zwei Gehäuseteilen (22, 23) aufgebaut ist, wobei das Gehäuse (1) eine zur Tragschiene (2) zugewandte Seite - Montageseite (5) - und eine Frontseite (10) aufweist, wobei die beiden/zwei der Gehäuseteile (22, 23) entlang einer Stoßkante (12), die zumindest teilweise entlang der Frontseite (10) verläuft, formschlüssig und voneinander trennbar zusammengefügt sind, wobei an der Frontseite (10) bei der Stoßkante (12) ein Bereich zum Anbringen eines Sicherungselementes - Sicherungsbereich - ausgebildet ist, wobei sich der Sicherungsbereich über mindestens zwei der Gehäuseteile (22, 23) erstreckt, **dadurch gekennzeichnet, dass** mindestens eines der Gehäuseteile (22, 23) in dem Sicherungsbereich eine Lasche (13, 14) aufweist, die in eine korrespondierende Ausnehmung (15, 16) an der Oberfläche des angrenzenden Gehäuseteils eingreift und die den an der Oberfläche des Gehäuses sichtbaren Verlauf der Stoßkante (12) verändert, wodurch bei einem Öffnen des Gehäuses (1) durch Verschwenken der Gehäuseteile (22, 23) relativ zueinander und entlang der Stoßkante (12) an der Frontseite (10) die Lasche (13, 14) und die Ausnehmung (15, 16) relativ zueinander verschwenken und dadurch Scherkräfte auf ein in dem Sicherungsbereich angebrachtes Sicherungselement entstehen.

2. Gehäuse nach Anspruch 1, **dadurch gekennzeichnet, dass** an oder in der Montageseite (5) ein Haltebereich (4) ausgebildet ist, der zur Aufnahme der Tragschiene (2) bei Montage des Gehäuses (1) auf der Tragschiene (2) ausgestaltet ist.

3. Gehäuse nach Anspruch 1 oder 2, **dadurch gekennzeichnet, dass** das Gehäuse (1) aus genau zwei Gehäuseteilen (22, 23) besteht und dass die beiden Gehäuseteile (22, 23) symmetrisch zueinander aufgebaut sind, wobei die Symmetrieachse vorzugsweise senkrecht zu der Frontseite (10) verläuft.

4. Gehäuse nach einem der Ansprüche 1 bis 3, **dadurch gekennzeichnet, dass** die an der Oberfläche des Gehäuses sichtbare Stoßkante (12) in dem Sicherungsbereich einen wellenförmigen und/oder gestuften Verlauf aufweist.

5. Gehäuse nach einem der Ansprüche 1 bis 4, **dadurch gekennzeichnet, dass** der Sicherungsbereich als planer Bereich an der Oberfläche der Frontseite (10) und zur Aufnahme eines Siegeletiketts (20) ausgebildet ist, wobei der plane Bereich vorzugsweise lediglich durch die Stoßkante (12) unterbrochen ist.

6. Gehäuse nach Anspruch 5, **dadurch gekennzeichnet, dass** der plane Bereich in einer Siegeltasche (24) in der Frontseite (10) ausgebildet ist, wobei die Siegeltasche (24) vorzugsweise durch eine kreisrunde oder rechteckförmige Vertiefung in der Oberfläche der Frontseite (10) gebildet ist und wobei die Lasche oder - bei mehreren Laschen im Sicherungsbereich - eine der Laschen vorzugsweise maximal 50% der Fläche der Siegeltasche (24) einnimmt.

7. Gehäuse nach einem der Ansprüche 1 bis 6, **dadurch gekennzeichnet, dass** in dem Sicherungsbereich in zwei in dem Sicherungsbereich angrenzenden Gehäuseteilen (22, 23) Laschen (30) ausgebildet sind, die zur Aufnahme einer Plombe (29) als Sicherungselement geeignet sind.

8. Gehäuse nach einem der Ansprüche 1 bis 7, **dadurch gekennzeichnet, dass** die Montageseite (5) und die Frontseite (10) an gegenüberliegenden Seite des Gehäuses (1) und vorzugsweise parallel zueinander ausgebildet sind.

9. Gehäuse nach einem der Ansprüche 1 bis 8, **dadurch gekennzeichnet, dass** an den Gehäuseteilen (22, 23) im Bereich der Stoßkante (12) Rastnasen ausgebildet sind, wobei die Rastnasen jeweils in korrespondierende Vertiefungen oder Durchbrüche (19) an oder in dem angrenzenden Gehäuseteil (22, 23) eingreifen und wobei vorzugsweise mindestens eine der Rastnasen oder eine der korrespondierenden Vertiefungen oder Durchbrüche (19) in der Lasche (13, 14) im Sicherungsbereich ausgebildet ist.

10. Gehäuse nach einem der Ansprüche 1 bis 9, **dadurch gekennzeichnet, dass** im Inneren des Gehäuses (1) Führungsschienen (27) zur Aufnahme einer Platine (31) ausgebildet sind.

11. Gehäuse nach einem der Ansprüche 1 bis 10, **dadurch gekennzeichnet, dass** das Gehäuse (1) zur Aufnahme von parallel und/oder senkrecht zu der Frontseite (10) angeordneten Platinen (31) ausgebildet ist.

12. Gehäuse nach einem der Ansprüche 1 bis 11, **dadurch gekennzeichnet, dass** das Gehäuse (1) eine Fügerichtung (26) aufweist, in der die zumindest zwei Gehäuseteile (22, 23) zusammengefügt werden, wobei die Fügerichtung (26) bei Ausbildung eines Haltebereichs zur Aufnahme der Tragschiene vorzugsweise parallel zu der Frontseite (10) und senkrecht zu dem Haltebereich (4).

13. Gehäuse nach einem der Ansprüche 1 bis 12, **dadurch gekennzeichnet, dass** das Gehäuse (1) als geschlossenes Gehäuse aufgebaut ist, das vorzugsweise lediglich durch Lüftungsschlitze und/oder Durchführungen für Anschlüsse (17) einer in dem Gehäuse (1) angeordneten Elektrobaugruppe und/oder Sichtbereiche für Anzeigen (18), insbesondere lichtemittierende Dioden - LEDs, durchbrochen ist.

14. Gehäuseanordnung bestehend aus einem Gehäuse nach einem der Ansprüche 1 bis 13 und einem Sicherungselement, das in dem Sicherungsbereich angebracht ist, wobei das Sicherungselement als Siegeletikett (20) ausgebildet ist und wobei das Sicherungselement derart ausgestaltet ist, dass es durch die Scherkräfte bei Öffnen des Gehäuses (1), insbesondere durch Verschwenken der Gehäuseteile (22, 23) relativ zueinander und entlang der Stoßkante (12) an der Frontseite (10), beschädigt wird.

15. Gehäuseanordnung bestehend aus einem Gehäuse nach einem der Ansprüche 1 bis 13 und einem Sicherungselement, wobei das Sicherungselement mittels eines Ultraschallstempels in dem Sicherungsbereich in das Gehäuse (1) eingeprägt ist und wobei das Sicherungselement derart ausgestaltet ist, dass es durch die Scherkräfte bei Öffnen des Gehäuses (1), insbesondere durch Verschwenken der Gehäuseteile (22, 23) relativ zueinander und entlang der Stoßkante (12) an der Frontseite (10), beschädigt wird.

## Claims

1. Housing for electrical sub-assemblies for assembly on a carrier rail, wherein the housing (1) is constructed from at least two housing portions (22, 23), wherein the housing (1) has a side - assembly side (5) - facing the carrier rail (2) and a front side (10), wherein both/two of the housing portions (22, 23) are joined together in a positive-locking manner and so as to be able to be separated from each other along an abutment edge (12) which extends at least partially along the front side (10),
wherein a region for fitting a securing element - securing region - is constructed at the front side (10) at the abutment edge (12), wherein the securing region extends over at least two of the housing portions (22, 23), **characterised in that** at least one of the housing portions (22, 23) in the securing region has a flap (13, 14) which engages in a corresponding recess (15, 16) in the surface of the adjacent housing portion and which changes the visible path of the abutment edge (12) at the surface of the housing, whereby, when the housing (1) is opened by pivoting the housing portions (22, 23) relative to each other and along the abutment edge (12) at the front side (10), the flap (13, 14) and the recess (15, 16) pivot relative to each other and shearing forces are thereby produced on a securing element which is fitted in the securing region.

2. Housing according to claim 1, **characterised in that** on or in the assembly side (5) there is constructed a retention region (4) which is configured to receive the carrier rail (2) when the housing (1) is assembled on the carrier rail (2).

3. Housing according to claim 1 or claim 2, **characterised in that** the housing (1) comprises precisely two housing portions (22, 23) and **in that** the two housing portions (22, 23) are constructed symmetrically with respect to each other, wherein the axis of symmetry preferably extends perpendicularly to the front side (10).

4. Housing according to any one of claims 1 to 3, **characterised in that** the visible abutment edge (12) on the surface of the housing has in the securing region an undulating and/or stepped path.

5. Housing according to any one of claims 1 to 4, **characterised in that** the securing region is constructed as a planar region on the surface of the front side (10) and for receiving a sealing label (20), wherein the planar region is preferably interrupted only by the abutment edge (12).

6. Housing according to claim 5, **characterised in that** the planar region is constructed in a sealing pocket (24) in the front side (10), wherein the sealing pocket (24) is preferably formed by a circular or rectangular recess in the surface of the front side (10) and wherein the flap or - in the case of a plurality of flaps in the securing region - one of the flaps preferably takes up a maximum of 50% of the surface-area of the sealing pocket (24).

7. Housing according to any one of claims 1 to 6, **characterised in that** in the securing region in two adjacent housing portions (22, 23) in the securing region there are formed flaps (30) which are suitable for receiving a seal (29) as a securing element.

8. Housing according to any one of claims 1 to 7, **characterised in that** the assembly side (5) and the front side (10) are constructed at opposing sides of the housing (1) and preferably parallel with each other.

9. Housing according to any one of claims 1 to 8, **characterised in that** catch projections are constructed on the housing portions (22, 23) in the region of the abutment edge (12), wherein the catch projections in each case engage in corresponding recesses or apertures (19) on or in the adjacent housing portion (22, 23) and wherein preferably at least one of the catch projections or one of the corresponding recesses or apertures (19) is constructed in the flap (13, 14) in the securing region.

10. Housing according to any one of claims 1 to 9, **characterised in that** guide rails (27) for receiving a circuit board (31) are constructed inside the housing (1).

11. Housing according to any one of claims 1 to 10, **characterised in that** the housing (1) is constructed to receive circuit boards (31) which are arranged parallel with and/or perpendicularly to the front side (10).

12. Housing according to any one of claims 1 to 11, **characterised in that** the housing (1) has a joining direction (26), in which the at least two housing portions (22, 23) are joined together, wherein the joining direction (26) when a retention region is constructed for receiving the carrier rail preferably parallel with the front side (10) and perpendicularly to the retention region (4).

13. Housing according to any one of claims 1 to 12, **characterised in that** the housing (1) is constructed as a closed housing, which is preferably perforated only by means of ventilation slots and/or apertures for connections (17) of an electronic sub-assembly which is arranged in the housing (1) and/or visible regions for indicators (18), in particular light-emitting diodes - LEDs.

14. Housing arrangement comprising a housing according to any one of claims 1 to 13 and a securing element which is fitted in the securing region, wherein the securing element is constructed as a sealing label (20) and wherein the securing element is constructed in such a manner that it is damaged by the shearing forces when the housing (1) is opened, in particular by pivoting the housing portions (22, 23) relative to each other and along the abutment edge (12) at the front side (10).

15. Housing arrangement comprising a housing according to any one of claims 1 to 13 and a securing element, wherein the securing element is imprinted in the housing (1) by means of an ultrasonic stamp in the securing region and wherein the securing element is constructed in such a manner that it is damaged by the shearing forces when the housing (1) is opened, in particular by pivoting the housing portions (22, 23) relative to each other and along the abutment edge (12) at the front side (10).

## Revendications

1. Boîtier pour des unités électriques pour un montage sur un rail porteur, le boîtier (1) étant constitué d'au moins deux moitiés de boîtier (22, 23), le boîtier (1) présentant un côté
- côté de montage (5) - tourné vers le rail porteur (2) et un côté frontal (10), les deux / deux des moitiés de boîtier (22, 23) étant assemblées par liaison de forme, de façon séparable les unes des autres, le long d'une arête de jonction (12) qui s'étend au moins partiellement le long du côté frontal (10), une zone destinée à la mise en place d'un élément de fixation
- zone de fixation - étant constituée sur le côté frontal (10) au niveau de l'arête de jonction (12), la zone de fixation s'étendant sur au moins deux des moitiés de boîtier (22, 23), **caractérisé en ce**
**qu'**au moins une des moitiés de boîtier (22, 23) présente dans la zone de fixation une languette (13, 14) qui engrène dans un creux (15, 16) correspondant sur la surface de la partie de boîtier adjacente et qui modifie le tracé visible de l'arête de jonction (12), ce qui fait que, lors d'une ouverture du boîtier (1) par pivotement des moitiés de boîtier (22, 23) les unes par rapport aux autres et le long de l'arête de jonction (12) sur le côté frontal (10), la languette (13, 14) et le creux (15, 16) pivotent l'un par rapport à l'autre, ce qui provoque l'apparition des forces de cisaillement sur un élément de fixation mis en place dans la zone de fixation.

2. Boîtier selon la revendication 1, **caractérisé en ce que** sur ou dans le côté de montage (5) il est formé une zone de retenue (4) qui est configurée pour la réception du rail porteur (2) lors du montage du boîtier (1) sur le rail porteur (2).

3. Boîtier selon la revendication 1 ou 2, **caractérisé en ce que** le boîtier (1) se compose de précisément deux parties de boîtier (22, 23), et **en ce que** les deux parties de boîtier (22, 23) sont constituées de façon symétrique l'une par rapport à l'autre, l'axe de symétrie s'étendant de préférence perpendiculairement au côté frontal (10).

4. Boîtier selon l'une des revendications 1 à 3, **caractérisé en ce que** l'arête de jonction (12) visible sur la surface du boîtier présente dans la zone de fixation un tracé ondulé et/ou étagé.

5. Boîtier selon l'une des revendications 1 à 4, **caractérisé en ce que** la zone de fixation est constituée en tant que zone plane sur la surface du côté frontal (10) et pour la réception d'une étiquette de scellement (20), la zone plane n'étant de préférence interrompue que par l'arête de jonction (12).

6. Boîtier selon la revendication 5, **caractérisé en ce que** la zone plane est formée dans une poche de scellement (24) dans le côté frontal (10), la poche de scellement (24) étant de préférence formée par une dépression circulaire ou rectangulaire dans la surface du côté frontal (10), et l'attache ou - dans le cas de plusieurs attaches dans la zone de fixation - une des attaches occupant de préférence au maximum 50 % de la surface de la poche de scellement (24).

7. Boîtier selon l'une des revendications 1 à 6, **caractérisé en ce que**, dans la zone de fixation, dans deux parties de boîtier (22, 23) adjacentes dans la zone de fixation, il est constitué des attaches (30) qui sont appropriées pour la réception d'un plomb (29) en tant qu'élément de fixation.

8. Boîtier selon l'une des revendications 1 à 7, **caractérisé en ce que** le côté de montage (5) et le côté frontal (10) sont constitués sur des côtés opposés du boîtier (1) et de préférence de façon parallèle entre eux.

9. Boîtier selon l'une des revendications 1 à 8, **caractérisé en ce que** des becs d'encliquetage sont constitués sur les parties de boîtier (22, 23) dans la zone de l'arête de jonction (12), les becs d'encliquetage engrenant respectivement dans des dépressions ou traversées (19) correspondantes sur ou dans la partie de boîtier (22, 23) adjacente, et de préférence au moins un des becs d'encliquetage ou une des dépressions ou traversées (19) correspondantes étant constitué(e) dans la languette (13, 14) dans la zone de fixation.

10. Boîtier selon l'une des revendications 1 à 9, **caractérisé en ce que** des rails de guidage (27) sont constitués dans l'intérieur du boîtier (1) pour la réception d'une platine (31).

11. Boîtier selon l'une des revendications 1 à 10, **caractérisé en ce que** le boîtier (1) est constitué pour la réception de platines (31) disposées parallèlement et/ou perpendiculairement au côté frontal (10).

12. Boîtier selon l'une des revendications 1 à 11, **caractérisé en ce que** le boîtier (1) présente une direction d'assemblage (26) dans laquelle les au moins deux parties de boîtier (22, 23) sont assemblées, la direction d'assemblage (26) étant, lors de la formation d'une zone de retenue pour la réception du rail porteur, de préférence parallèle au côté frontal (10) et perpendiculaire à la zone de retenue (4).

13. Boîtier selon l'une des revendications 1 à 12, **caractérisé en ce que** le boîtier (1) est constitué en tant que boîtier fermé qui n'est de préférence traversé que par des fentes de ventilation et/ou des passages pour des connexions (17) d'une unité électrique disposée dans le boîtier (1) et/ou des zones de vision pour des affichages (18), en particulier des diodes électroluminescentes - LED.

14. Agencement de boîtier, composé d'un boîtier selon l'une des revendications 1 à 13 et d'un élément de fixation qui est mis en place dans la zone de fixation, l'élément de fixation étant constitué en tant qu'étiquette de scellement (20), et l'élément de fixation étant constitué de telle sorte qu'il est endommagé par les forces de cisaillement lors de l'ouverture du boîtier (1), en particulier par le pivotement des parties de boîtier (22, 23) les unes par rapport aux autres et le long de l'arête de jonction (12) sur le côté frontal (10).

15. Agencement de boîtier, composé d'un boîtier selon l'une des revendications 1 à 13 et d'un élément de fixation, l'élément de fixation étant, au moyen d'un poinçon par ultrasons, gravé dans la zone de fixation dans le boîtier (1), et l'élément de fixation étant constitué de telle sorte qu'il est endommagé par les forces de cisaillement lors de l'ouverture du boîtier, en particulier par le pivotement des parties de boîtier (22, 23) les unes par rapport aux autres et le long de l'arête de jonction (12) sur le côté frontal (10).
